# EUROPEAN PATENT SPECIFICATION

(11) **EP 2 665 101 B1**
(45) Date of publication and mention of the grant of the patent: **31.10.2018**
(21) Application number: 12167851.0
(22) Date of filing: 14.05.2012
(51) Int. Cl.: H01L 29/78, H01L 29/08, H01L 21/336, H01L 21/266, H01L 29/423

(54) **Method of producing a high-voltage LDMOS transistor**
Verfahren zur Herstellung eines Hochspannungs-LDMOS-Transistors
Procédé de fabrication d'un transistor LDMOS haute tension

(43) Date of publication of application: 20.11.2013
(73) Proprietor: ams AG, 8141 Premstätten (AT)
(72) Inventor: Park, Jong Mun, 8010 Graz (AT); Minixhofer, Rainer, 8141 Premstätten (AT)
(74) Representative: Epping - Hermann - Fischer

(56) References cited:
- EP-A1- 0 755 073
- US-A1- 2005 230 765
- US-A1- 2006 027 863
- VESCOLI V ET AL: "3D-Resurf: The integration of a p-channel LDMOS in a standard CMOS process", PROCEEDINGS OF THE 20TH INTERNATIONAL SYMPOSIUM ON POWER SEMICONDUCTOR DEVICES AND IC'S (ISPSD '08), ORLANDO, FL, USA, 18 May 2008 (2008-05-18), - 22 May 2008 (2008-05-22), pages 123-126, XP031269950, IEEE, NEW YORK, NY, USA ISBN: 978-1-4244-1532-8
- HARDIKAR S ET AL: "Realizing High-Voltage Junction Isolated LDMOS Transistors With Variation in Lateral Doping", IEEE TRANSACTIONS ON ELECTRON DEVICES, vol. 51, no. 12, December 2004 (2004-12), pages 2223-2228, XP011122810, IEEE, NEW YORK, NY, USA ISSN: 0018-9383, DOI: 10.1109/TED.2004.839104

## Description

The present invention relates to the production of high-voltage LDMOS transistors, especially high-voltage p-channel LDMOS transistors.

EP 0676799 B1 describes a high-voltage p-channel LDMOS comprising a substrate of either type of conductivity, an n-well, and a p-tank lying within the n-well and providing a RESURF drift region. A drain is formed within the p-tank. A source is formed within the n-well and is separated from the p-tank by a channel region. An n-well contact is formed within the n-well. A field oxide overlies a portion of the drift region. A gate oxide overlies the channel region and the rim of the drift region. A gate electrode overlies the gate oxide and the field oxide. In the rim area of the drift region the impurity concentration segregates out of the p-tank, leaving a shallow vertical junction under the field oxide, which degrades the performance of the PMOS device. An additional implant re-establishes the impurity concentration in the rim area of the drift region.

US 2005/0230765 A1 discloses a mask having a gradually changing opening ratio for impurity implantation into a semiconductor device.

US 2006/0027863 A1 discloses a method of forming a lateral MOSFET, which uses a mask with a plurality of square openings for an implantation in the drift region to form an n-type well in a p-type substrate.

EP 0755073 A1 discloses a method of producing a high-voltage transistor. A well including the drift region and the drain region is produced by an implantation of a dopant using a patterned resist mask, which may comprise a pattern including rectangles and squares having constant distances from one another.

The publication of V. Vescoli et al.: "3D-Resurf: The integration of a p-channel LDMOS in a standard CMOS process", Proc. ISPSD 2008, p. 123 - 126, reports on an LDMOS device comprising a plurality of rectangular PWELL stripes that are confined in directions both along the drift region and transverse to the drift region.

The publication of S. Hardikar et al.: "Realizing High-Voltage Junction Isolated LDMOS Transistors With Variation in Lateral Doping", IEEE Trans. Electron Devices vol. 51, p. 2223 - 2228 (2004), shows an implantation mask having openings of varying dimensions and distances.

An object of the invention is to facilitate the production of LDMOS transistors for operating voltages of more than 100 V with implantations that are provided to produce LDMOS transistors for operating voltages of typically 50 V.

This object is achieved with the method according to claim 1. Variants derive from the dependent claims.

The method for producing a high-voltage LDMOS transistor comprises the steps of forming a first well having a doping of a first type of conductivity in a semiconductor substrate, a second well of an opposite second type of conductivity in the first well, a source region of the second type of conductivity in the first well outside the second well, a drain region of the second type of conductivity in the second well, leaving a drift region in the second well between the drain region and the source region, and a bulk contact region of the first type of conductivity in the first well. A gate dielectric and a gate electrode are arranged on a section of the first well that is present between the second well and the source region and is intended as a channel region. The doping concentration of the drift region is reduced in relation to the maximal doping concentration of the second well by using an implantation mask with a patterned window comprising openings that are confined in the direction of the drift region and transverse to the direction of the drift region.

The mask is used for an implantation of the first type of conductivity, and the patterned window is provided for a partial counterdoping of the doping of the second type of conductivity in the area of the drift region.

In a variant of the method the openings of the patterned window are adapted to a formation of a drift region that is provided for an operating voltage of the transistor in the range between 100 V and 300 V.

In a further variant of the method the openings of the patterned window are a plurality of circular or rectangular holes, which may form a sieve structure.

In a further variant of the method the openings of the patterned window are arranged at equal distances along the drift region or at equal distances transverse to the drift region or at equal distances both along the drift region and transverse to the drift region.

In a further variant of the method the openings of the patterned window are arranged sufficiently dense for the formation of a continuous drift region without subsequent annealing step.

The first type of conductivity may be n-type conductivity and the second type of conductivity p-type conductivity, rendering a p-channel LDMOS. Instead, the first type of conductivity may be p-type conductivity and the second type of conductivity n-type conductivity, rendering an n-channel LDMOS.

The following is a detailed description of examples of the method in conjunction with the accompanying drawings.
Figure 1 shows a cross section of an LDMOS transistor and an implantation mask according to the invention.
Figure 2 shows a schematical top view of the LDMOS transistor and the implantation mask according to the invention.

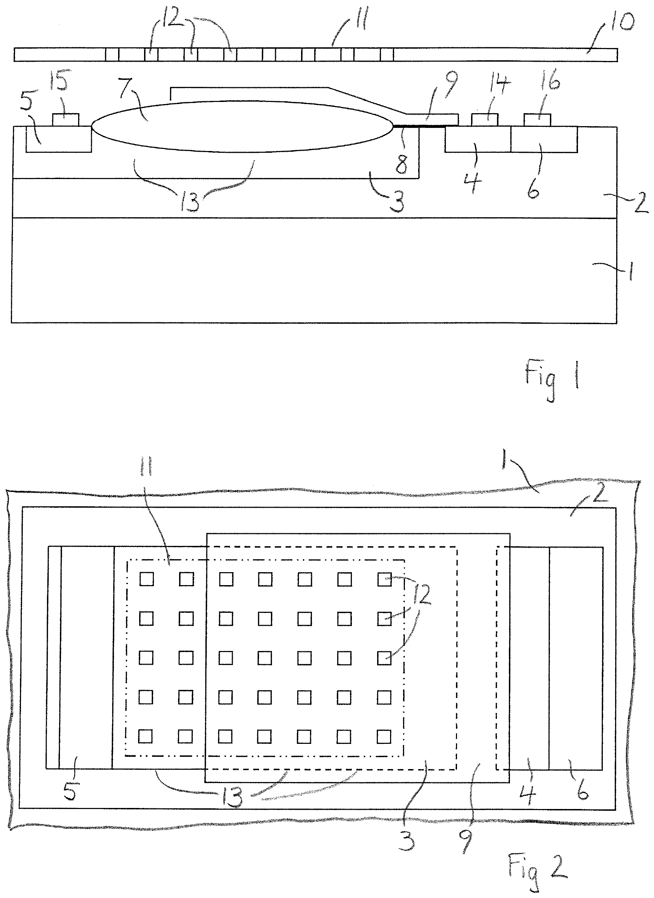

Figure 1 shows a cross section of a high-voltage LDMOS transistor comprising a semiconductor substrate 1 with a first well 2 of a first type of conductivity and a second well 3 of the opposite second type of conductivity arranged in the first well 2. A source region 4 of the second type of conductivity is arranged in the first well 2 outside the second well 3, a drain region 5 of the second type of conductivity is arranged in the second well 3, and a bulk contact region 6 of the first type of conductivity is arranged in the first well 2 outside the second well 3. The source region 4, the drain region 5, and the bulk contact region 6 may be provided with a source contact 14, a drain contact 15 and a body contact 16, respectively. The first type of conductivity may be n-type conductivity and the second type of conductivity p-type conductivity or vice versa, for the production of a p-channel LDMOS or an n-channel LDMOS, respectively. A gate dielectric 8 and a gate electrode 9 are arranged on a channel region, which is provided by a section of the first well 2 that is present between the second well 3 and the source region 4.

A drift region 13 is located within the second well 3 between the source region 4 and the drain region 5. The drift region 13 is preferably covered with an insulation region 7, which is arranged between the drain region 5 and the gate dielectric 8 and may be a field oxide or a shallow trench isolation (STI). The gate electrode 9 may extend on the insulation region 7, thus forming a field plate, which modifies the electric field in the drift region 13.

Figure 1 shows a mask 10 comprising a patterned window 11 provided with openings 12 arranged above the transistor device. According to the invention the mask 10 is used to implant dopants of the first type of conductivity as to partially counterdope the original doping of the drift region 13 in order to produce a reduced net doping concentration in the drift region 13.

According to an example useful for understanding the present invention the mask 10 is used to implant dopants of the second type of conductivity as to produce the second well 3 with a reduced doping concentration in the drift region. Figure 1 shows the arrangement of the patterned window 11 with respect to the transistor structure, including elements of the transistor that are not yet present when the implantation using the mask 10 is performed. The implantation of the second well 3 may take place using the mask 10 particularly before the formation of the source region 4, the drain region 5, the bulk contact region 6, the insulation region 7, and the gate electrode 9. Instead, a counterdoping using the mask 10 may take place before the formation of the source region 4, the drain region 5, the bulk contact region 6, the insulation region 7, and the gate electrode 9, for example.

Figure 2 shows a top view of the well structure of the LDMOS transistor and of the arrangement of the patterned window 11. The corresponding elements are designated with the same reference numerals as in Figure 1. Figure 2 shows the relative positions of the first well 2, the second well 3 and the source region 4, which are partially covered by the gate electrode 9, the drain region 5, and the bulk contact region 6. The hidden contours are indicated with broken lines.

The drift region 13 extends, in its longitudinal direction, from the common boundary of the second well 3 and the channel region to the drain region 5. The patterned window 11 comprises openings 12 which are confined in directions both along the drift region 13 and transverse to the drift region 13. The openings 12 are therefore substantially different from narrow strips extending along or across the drift region 13, as they may be used for transistors that are provided for operating voltages above 300 V.

The openings 12 may be a plurality of circular or rectangular holes, for instance. Their arrangement may be symmetrical or periodical in one or more directions or may form a sieve structure. The openings 12 may be arranged at equal distances along the longitudinal extension of the drift region 13 or transverse to the drift region or at equal distances both along the drift region and transverse to the drift region. The openings are preferably sufficiently dense for the formation of a continuous drift region 13 without necessitating a subsequent annealing step. Their density may be adapted to the production of transistors that are provided for operating voltages in the range between 100 V and 300 V. The invention enables the production of high-voltage LDMOS transistors, particularly high-voltage p-channel LDMOS transistors, with conventional well implants. The patterned window is used for a local counterdoping of a previously implanted doping. The density, position and size of the openings 12 of the patterned window 11 can easily be adjusted to optimize the doping concentration of the drift region for the desired transistor types.

The openings can be varied from smallest dimensions, according to a minimum design rule, for instance, up to dimensions in the order of micrometers, typically 0.1 to 3 µm, for example. The portion of the patterned window 11 that is covered by the openings 12 may vary in a wide range and may be as large as 80 % of the total area of the patterned window 11.

It is also possible to use multiple windows, depending on the length of the drift region 13 and the desired properties of the transistor device. Multiple windows allow the density of the openings 12 to vary locally. Areas in which the openings 12 are rather dense may be separated by intermediate areas which comprise only sparse openings or are void of openings.

The method has the advantages that no additional mask and no additional alignment are necessary and that the implanted dose can flexibly be controlled according to the requirements of the individual embodiments of the transistor device.

### List of reference numerals

- 1: substrate
- 2: first well
- 3: second well
- 4: source region
- 5: drain region
- 6: body contact region
- 7: insulation region
- 8: gate dielectric
- 9: gate electrode
- 10: mask
- 11: pattern window
- 12: opening
- 13: drift region
- 14: source contact
- 15: drain contact
- 16: body contact

## Claims

1. Method for producing a high-voltage LDMOS transistor, comprising:
- forming a first well (2) having a doping of a first type of conductivity in a semiconductor substrate (1),
- forming a second well (3) having a doping of an opposite second type of conductivity in the first well (2),
- forming a source region (4) of the second type of conductivity in the first well (2) outside the second well (3),
- forming a drain region (5) of the second type of conductivity in the second well (3), leaving a drift region (13) in the second well (3) between the drain region (5) and the source region (4),
- forming a bulk contact region (6) of the first type of conductivity in the first well (2), and
- arranging a gate dielectric (8) and a gate electrode (9) on a section of the first well (2) that is present between the second well (3) and the source region (4), wherein
an implantation of the first type of conductivity is performed into the second well (3) in an area of the drift region (13) by using an implantation mask (10) with a patterned window (11) comprising openings (12) that are confined in directions both along the drift region (13) and transverse to the drift region (13), the implantation producing a reduced net doping concentration in the drift region (13).

2. Method according to claim 1, wherein
the openings (12) of the patterned window (11) are adapted to a formation of a drift region (13) that is provided for an operating voltage of the transistor in the range between 100 V and 300 V.

3. Method according to claim 1 or 2, wherein
the openings (12) of the patterned window (11) are a plurality of circular or rectangular holes.

4. Method according to claim 1 or 2, wherein
the openings (12) of the patterned window (11) form a sieve structure.

5. Method according to claim 1 or 2, wherein
the openings (12) of the patterned window (11) are arranged at equal distances along the drift region (13) or transverse to the drift region or both along the drift region and transverse to the drift region.

6. Method according to claim 1 or 2, wherein
the openings (12) of the patterned window (11) are arranged sufficiently dense for the formation of a continuous drift region (13) without subsequent annealing step.

## Patentansprüche

1. Verfahren zum Herstellen eines Hochspannungs-LDMOS-Transistors, Folgendes umfassend:
- Ausbilden einer ersten Wanne (2) mit einer Dotierung eines ersten Leitfähigkeitstyps in einem Halbleitersubstrat (1),
- Ausbilden einer zweiten Wanne (3) mit einer Dotierung eines entgegengesetzten, zweiten Leitfähigkeitstyps in der ersten Wanne (2),
- Ausbilden einer Source-Zone (4) des zweiten Leitfähigkeitstyps in der ersten Wanne (2) außerhalb der zweiten Wanne (3),
- Ausbilden einer Drain-Zone (5) des zweiten Leitfähigkeitstyps in der zweiten Wanne (3), wobei eine Drift-Zone (13) in der zweiten Wanne (3) zwischen der Drain-Zone (5) und der Source-Zone (4) belassen wird,
- Ausbilden einer Massekontaktzone (6) des ersten Leitfähigkeitstyps in der ersten Wanne (2) und
- Anordnen eines Gate-Dielektrikums (8) und einer Gate-Elektrode (9) auf einem Abschnitt der ersten Wanne (2), der zwischen der zweiten Wanne (3) und der Source-Zone (4) vorhanden ist,
wobei eine Implantation des ersten Leitfähigkeitstyps in die zweite Wanne (3) in einem Bereich der Drift-Zone (13) erfolgt, indem eine Implantationsmaske (10) mit einem strukturierten Fenster (11) verwendet wird, das Öffnungen (12) aufweist, die in Richtungen sowohl entlang der Drift-Zone (13) als auch quer zur Drift-Zone (13) begrenzt sind, wobei die Implantation eine reduzierte Nettodotierkonzentration in der Drift-Zone (13) erzeugt.

2. Verfahren nach Anspruch 1, wobei
die Öffnungen (12) des strukturierten Fensters (11) an eine Ausbildung einer Drift-Zone (13) angepasst sind, die für eine Betriebsspannung des Transistors im Bereich zwischen 100 V und 300 V vorgesehen ist.

3. Verfahren nach Anspruch 1 oder 2, wobei
es sich bei den Öffnungen (12) des strukturierten Fensters (11) um mehrere kreisförmige oder rechteckige Löcher handelt.

4. Verfahren nach Anspruch 1 oder 2, wobei
die Öffnungen (12) des strukturierten Fensters (11) eine Siebstruktur bilden.

5. Verfahren nach Anspruch 1 oder 2, wobei
die Öffnungen (12) des strukturierten Fensters (11) in gleichen Abständen entlang der Drift-Zone (13) oder quer zur Drift-Zone oder sowohl entlang der Drift-Zone als auch quer zur Drift-Zone angeordnet sind.

6. Verfahren nach Anspruch 1 oder 2, wobei
die Öffnungen (12) des strukturierten Fensters (11) zur Ausbildung einer durchgehenden Drift-Zone (13) ohne anschließenden Warmbehandlungsschritt ausreichend dicht angeordnet sind.

## Revendications

1. Procédé de production d'un transistor LDMOS à haute tension, comprenant :
- la formation d'un premier puits (2) présentant un dopage d'un premier type de conductivité dans un substrat semiconducteur (1),
- la formation d'un deuxième puits (3) présentant un dopage d'un deuxième type de conductivité opposé dans le premier puits (2),
- la formation d'une région de source (4) du deuxième type de conductivité dans le premier puits (2) à l'extérieur du deuxième puits (3),
- la formation d'une région de drain (5) du deuxième type de conductivité dans le deuxième puits (3), laissant une région de migration (13) dans le deuxième puits (3) entre la région de drain (5) et la région de source (4),
- la formation d'une région de contact de corps (6) du premier type de conductivité dans le premier puits (2), et
- l'agencement d'un diélectrique de grille (8) et d'une électrode de grille (9) sur une section du premier puits (2) qui est présente entre le deuxième puits (3) et la région de source (4),
sachant qu'une implantation du premier type de conductivité est effectuée dans le deuxième puits (3) dans une zone de la région de migration (13) au moyen d'un masque d'implantation (10) avec une fenêtre (11) à motif présentant des ouvertures (12) qui sont confinées dans des directions à la fois le long de la région de migration (13) et transversalement à la région de migration (13), l'implantation produisant une concentration de dopage nette réduite dans la région de migration (13).

2. Procédé selon la revendication 1, sachant que
les ouvertures (12) de la fenêtre (11) à motif sont adaptées pour une formation d'une région de migration (13) qui est prévue pour une tension de fonctionnement du transistor dans la plage comprise entre 100 V et 300 V.

3. Procédé selon la revendication 1 ou 2, sachant que
les ouvertures (12) de la fenêtre (11) à motif sont une pluralité de trous circulaires ou rectangulaires.

4. Procédé selon la revendication 1 ou 2, sachant que
les ouvertures (12) de la fenêtre (11) à motif forment une structure en tamis.

5. Procédé selon la revendication 1 ou 2, sachant que
les ouvertures (12) de la fenêtre (11) à motif sont agencées à égales distances le long de la région de migration (13) ou transversalement à la région de migration ou à la fois le long de la région de migration et transversalement à la région de migration.

6. Procédé selon la revendication 1 ou 2, sachant que
les ouvertures (12) de la fenêtre (11) à motif sont agencées de façon suffisamment dense pour la formation d'une région de migration (13) continue sans étape de recuit subséquente.
